# EUROPÄISCHE PATENTSCHRIFT

(11) **EP 0 794 268 B1**
(45) Veröffentlichungstag und Bekanntmachung des Hinweises auf die Patenterteilung: **18.08.1999**
(21) Anmeldenummer: 97102149.8
(22) Anmeldetag: 11.02.1997
(51) Int. Cl.: C23C 14/58

(54) **Verfahren zur Verbesserung des Korrosionsschutzes von aluminiumbeschichteten Oberflächen**
Process for improving corrosion protection of aluminium coated surfaces
Procédé pour améliorer la protection contre la corrosion des surfaces revêtues d'aluminium

(30) Priorität: 06.03.1996 DE 19608731
(43) Veröffentlichungstag der Anmeldung: 10.09.1997
(73) Patentinhaber: Vacuumschmelze GmbH, 63450 Hanau (DE)
(72) Erfinder: Zapf, Lothar, Dr., 63755 Alzenau (DE)
(74) Vertreter: Epping, Wilhelm, Dr.-Ing.

(56) Entgegenhaltungen:
- EP-A- 0 143 731
- GB-A- 915 452
- US-A- 5 399 438
- DATABASE WPI Week 7801 Derwent Publications Ltd., London, GB; AN 78-01536 XP002032668 "Sintered permanent magnets mfg. method - by aluminium coating and heat treatment in air, generally improves performance and product quality" & SU 549 266 A (BAIKOV METALLURGY INST) , 30.Mai 1977
- AHMED N A G ET AL: "Ion vapour deposition for corrosion protection of permanent magnets" , MODERN MAGNETIC MATERIALS. CONFERENCE PROCEEDINGS (ERA REPORT 89-0278), LONDON, UK, 20-21 JUNE 1989 , ISBN 0-7008-0389-0, 1989, LEATHERHEAD, UK, ERA TECHNOL, UK, PAGE(S) 8.3/1 - 9 XP000675705 * das ganze Dokument *

## Beschreibung

Die Erfindung betrifft ein Verfahren zur Verbesserung des Korrosionsschutzes von Oberflächen bei Magneten, die Seltene Erde enthalten, wobei die Oberflächen mit Aluminium oder einer überwiegend aus Aluminium bestehenden Legierung beschichtet sind.

Magnete, die Seltene Erde enthalten, wie z. B. NdFeB-Magnete, weisen wegen der Affinität zu Sauerstoff eine starke Neigung zu Korrosion auf. Beim Einsatz von derartigen Teilen in korrosionsfördernden Atmosphären, wie z. B. in einer Umgebung mit hoher Feuchtigkeit oder in salzhaltiger Umgebung, ist es daher erforderlich, dieses Magnetmaterial durch eine korrosionshemmende Beschichtung zu schützen. Hierzu sind neben Lackierverfahren Beschichtungen mit Nickel, Zinn oder Aluminium gebräuchlich.

Aus der SU 549 266 A ist bekannt, einen SmCo-Magneten auf elektrolytischem Wege mit Aluminium zu beschichten. Der mit einer Aluminiumschicht versehene SmCo-Magnet wird für 20 Minuten in Luft auf 1100 °C aufgeheizt, anschließend auf 900 °C abgekühlt, während drei Stunden auf dieser Temperatur gehalten und anschließend in einem Luftstrom abgekühlt.

Aus der Veröffentlichung "Coating Technology on Nd Magnet" von T. Minowa (Gorham Int. Conference) 1989 ist ein weiteres Beschichtungsverfahren bekannt. Bei einer Beschichtung mit Aluminium verwendet man im allgemeinen das sogenannte Ionenplattierverfahren, das auch IVD-Prozess genannt wird, wobei IVD für "ion vapor deposition" steht. Hier wird das Aluminium verdampft und mit einer Spannung von 1 bis 5 kV auf die Oberfläche eines negativ geladenen Teils aufgebracht.

Daneben ist die galvanische Abscheidung von Aluminium aus nichtwässrigen Elektrolytlösungen möglich. Auch können auf jede beliebige andere bekannte Art Aluminiumschichten auf derartige Magnete aufgebracht werden.

Theoretisch ist es auch denkbar, nicht reines Aluminium, sondern Aluminiumlegierungen zur Beschichtung zu verwenden, die dann allerdings überwiegend aus Aluminium bestehen sollten.

Magnete mit derartiger Beschichtung haben besondere Vorteile gegen Korrosion in salzhaltigen Atmosphären. Bei derartigen Umgebungen ist Aluminium resistenter gegenüber Korrosion als Teile, die z. B. mit Nickel beschichtet sind. Beispielsweise ergibt sich bei einer Besprühung mit 5 %iger NaCl-Lösung bei nickelbeschichteten Teilen eine Standzeit von unter 100 h, während aluminiumbeschichtete Teile mehr als 1000 h einer Korrosion widerstehen.

Anders verhält es sich, wenn die Umgebung nicht salzhaltige Luft ist, sondern wenn es sich um eine besonders feuchte Umgebung bei relativ warmen Temperaturen handelt. Bei einem Korrosionstest mit einer Umgebungstemperatur von 85 °C und einer relativen Luftfeuchte von 85 % ergibt sich typischerweise für nickelbeschichtete Magnete eine Standzeit von 1000 h, während die Standzeit bei aluminiumbeschichteten Magneten nur 500 h beträgt. Ähnlich verhält es sich bei dem sogen. HAST-Test (HAST = highly accelerated steam test). Hier wird eine dampfhaltige Atmosphäre mit einer Temperatur von 130 °C bei einem Druck von 2,7 bar angewendet. In einer derartigen Atmosphäre erhält man für nickelbeschichtete Teile eine Standzeit von 50 bis 100 h, während die Standzeit für aluminiumbeschichtete Teile unter 50 h liegt.

Für viele Anwendungen, insbesondere aus dem Automobilbereich, benötigt man jedoch ein Beschichtung, die sowohl Beständigkeit im Feuchteklima, als auch Resistenz gegenüber salzhaltiger Luft aufweist. Derartige Forderungen hinsichtlich der Korrosionsbeständigkeit wurden bisher dadurch erfüllt, daß man die Teile mit einer Doppelbeschichtung herstellte. Hier wird beispielsweise eine Schicht von > 20 um Nickel und eine Schicht von > 20 um Zinn auf das zu schützende Teil, z. B. den NdFeB-Magneten aufgebracht.

Eine derartige Doppelbeschichtung hat jedoch den Nachteil, daß sie einen wesentlich höheren wirtschaftlichen Aufwand erfordert. Durch die zwangsläufig größere Dicke der nichtmagnetischen Schicht wird der Anteil des magnetisch wirksamen Materials relativ zum Gesamtvolumen niedriger, so daß Zugeständnisse hinsichtlich magnetischer Eigenschaften im Magnetsystem und auch Zugeständnisse bei den realisierbaren Toleranzen für die Magnete gemacht werden müssen.

Aufgabe der vorliegenden Erfindung ist es, ein Verfahren anzugeben, das aluminiumbeschichtete Magnete, die Selbene Erden enthalten, hinsichtlich der Korrosionsbeständigkeit so verbessert, daß nicht nur gegenüber salzhaltiger Luft, sondern auch im Feuchteklima eine wesentlich höhere Korrosionsbeständigkeit erreicht wird.

Diese Aufgabe wird erfindungsgemäß dadurch gelöst, daß die magnete mit den beschichteten Oberflächen für mindestens 1h einer Wärmebehandlung bei einer Temperatur im Bereich von 450 °C und 550 °C, jedoch unterhalb der Schmelztemperatur der Beschichtung unterzogen werden.

Bevorzugte Ausführungsformen sind in den Unteransprüchen angegeben werden.

Die Dauer der Wärmebehandlung sollte typischerweise 1 bis 3 h betragen. Mit einer derartigen Wärmebehandlung erreicht man, daß beim Test mit 85 °C und 85 % relativer Feuchte Standzeiten von mehr als 1000 Stunden erreicht werden. Auch bei dem HAST-Test erreicht man Standzeiten wie bei Teilen mit Nickelbeschichtung im Bereich von 100 h.

Es wurde festgestellt, daß selbst Magnete mit Fehlstellen oder Beschädigungen in der Schicht nur eine dünne Rotrostschicht aufweisen, ohne daß der sonst durch Korrosion hervorgerufene pulverige Zerfall des Magneten einsetzt.

Durch das erfindungsgemäße Verfahren ist es also zusätzlich möglich, beschichtete Magnete mit Fehlstellen in der Beschichtung weiterzuverwenden, ohne daß wegen der Gefahr vorzeitiger Korrosion eine Verschrottung erforderlich wird. Die Wärmebehandlung kann sowohl an Luft als auch unter Schutzgas erfolgen. Eine Messung der Magnetwerte hat ergeben, daß die Wärmebehandlung keinerlei Änderung an den magnetischen Eigenschaften hervorruft.

In einem Ausführungsbeispiel wurden 10 Magnete in zwei Gruppen zu je fünft Stück aufgeteilt. Die eine Gruppe wurde einer Temperung von 1 h bis 500 °C unter Luft ausgesetzt. Eine vergleichende magnetische Messung ergab keinerlei Unterschiede vor und nach der Temperung. Beide Gruppen wurden nun einem HAST-Test bei 130 °C und einem Druck von 2,7 bar ausgesetzt. Bereits nach 16 h begann der erste ungetemperte Magnet eine leichte Delamination, also eine beginnende Ablösung der Schicht, auszubilden. Nach 32 h waren alle fünf Magnete der nicht getemperten Gruppe stark korrodiert (Beschichtung delaminiert, pulvriger Zerfall des Magneten). Dagegen zeigten alle fünf getemperten NdFeB-Magnete auch nach 100 h Belastung noch keinerlei Korrosionserscheinungen.

## Patentansprüche

1. Verfahren zur Verbesserung des Korrosionsschutzes von Oberflächen bei Magneten, die Seltene Erde enthalten, wobei die Oberflächen mit Aluminium oder einer überwiegend aus Aluminium bestehenden Legierung beschichtet sind,
**dadurch gekennzeichnet,**
daß die magnete mit den beschichteten Oberflächen für mindestens 1 h einer Wärmebehandlung bei einer Temperatur im Bereich von 450 bis 550 °C, jedoch unterhalb der Schmelztemperatur der Beschichtung, unterzogen werden.

2. Verfahren nach Anspruch 1,
**dadurch gekennzeichnet,**
daß es bei aluminiumbeschichteten NdFeB-Magneten verwendet wird.

3. Verfahren nach Anspruch 2,
**dadurch gekennzeichnet,**
daß es bei NdFeB-Magneten verwendet wird, die mit Hilfe des Ionenplattierprozesses mit einer Aluminiumschicht überzogen sind.

## Claims

1. Process for improving the corrosion resistance of surfaces on magnets which contain rare-earth elements, the surfaces being coated with aluminium or an alloy which consists predominantly of aluminium, characterized in that the coated surfaces of the magnets are subjected to a heat treatment for at least 1 h at a temperature in the range from 450 to 550°C, but below the melting temperature of the coating.

2. Process according to Claim 1, characterized in that it is used for aluminium-coated NdFeB magnets.

3. Process according to Claim 2, characterized in that it is used for NdFeB magnets which have been coated with a layer of aluminium using the ion vapour deposition process.

## Revendications

1. Procédé pour améliorer la protection contre la corrosion de surfaces pour des aimants, qui contiennent des terres rares, les surfaces étant revêtues d'aluminium ou d'un alliage composé principalement d'aluminium, caractérisé en ce que les aimants avec les surfaces revêtues sont soumis pendant au moins 1 h à un traitement thermique à une température allant de 450 à 550°C, inférieure cependant à la température de fusion du revêtement.

2. Procédé selon la revendication 1, caractérisé en ce qu'il est utilisé pour des aimants au NdFeB revêtus d'aluminium.

3. Procédé selon la revendication 2, caractérisé en ce qu'il est utilisé pour des aimants au NdFeB, qui sont recouverts d'une couche d'aluminium à l'aide du processus de placage ionique.
